# FASCICULE DE BREVET EUROPEEN

(11) **EP 1 561 236 B1**
(45) Date de publication et mention de la délivrance du brevet: **18.06.2008**
(21) Numéro de dépôt: 03769576.4
(22) Date de dépôt: 05.09.2003
(51) Int. Cl.: H01L 21/677

(54) **SYSTEME DE TRANSPORT ET STOCKAGE DE CONTENEURS DE PLAQUES DE SEMI-CONDUCTEUR**
TRANSPORT- UND LAGERUNGSSYSTEM FÜR HALBLEITERSCHEIBENBEHÄLTER
SYSTEM OF TRANSPORTING AND STORING CONTAINERS OF SEMICONDUCTOR WAFERS

(30) Priorité: 06.09.2002 FR 0211049
(43) Date de publication de la demande: 10.08.2005
(73) Titulaire: Recif Technologies, 31703 Blagnac Cedex (FR)
(72) Inventeur: POLI, Bernard, F-31480 Cox (FR); GAUDON, Bernard, F-31330 Launac (FR); LERO, Christophe, F-31490 Legeuvin (FR); HADDAD, Florent, F-31840 Seilh (FR)
(74) Mandataire: Morelle, Guy Georges Alain
(86) Numéro de dépôt international: PCT/FR2003/002652
(87) Numéro de publication internationale: WO 2004/023530

(56) Documents cités:
- EP-A- 1 079 421
- WO-A-00/37338
- WO-A-01/96884
- WO-A-99/02436

## Description

La présente invention se rapporte aux transport et stockage de conteneurs de plaques de semi-conducteur dans les centres de fabrication de plaques de semi-conducteur, et plus particulièrement à un système intégré apte à transférer et stocker des conteneurs de plaques de semi-conducteur entre des outils de traitement des plaques de semi-conducteur disposés dans une travée d'outils de traitement d'un centre de fabrication de plaques de semi-conducteur, et à un mécanisme de transfert de conteneurs destiné à être utilisé dans un système de transport et de stockage de conteneurs de plaques de semi-conducteur.

Les plaques de semi-conducteur sont transportées et traitées dans des conditions garantissant un environnement propre, dans lequel le nombre et la taille des particules en suspension dans l'air sont contrôlés, correspondant à des technologies précises, notamment la technologie SMIF. A cet effet, les plaques de semi-conducteur sont placées dans des conteneurs étanches lors de leur transport, ces conteneurs étant appliqués contre des ouvertures de chargement et déchargement des plaques, disposées sur les outils de traitement qui opèrent sous atmosphère contrôlée, afin de transférer lesdites plaques dans lesdits outils de traitement de ces plaques aux moyens de robots appropriés disposés dans les outils. Une travée de centre de fabrication de plaques comporte généralement plusieurs outils de traitement des plaques, donc plusieurs ouvertures de chargement et déchargement des plaques, et les conteneurs sont transportés d'une travée à l'autre dans le centre au moyen d'une ligne d'alimentation ou transporteur inter-travée utilisant en général un rail suspendu cheminant au dessus des ouvertures de chargement/déchargement, et un ascenseur permettant la descente et la montée d'un conteneur en face d'une ouverture, à partir du rail suspendu. Les vitesses de traitement des plaques dans chaque outil de traitement d'une travée sont différentes, ce qui induit des problèmes de gestion des flux de conteneurs dans les travées et la nécessité de l'adoption de zones de stockage tampon ou temporaire. Entre un outil à débit normal de plaques et un outil de métrologie à faible débit, qui peuvent se trouver tous deux dans une même travée, il peut exister une différence de débit de l'ordre de 25 conteneurs par heure pour conserver à chaque outil un rendement optimal.

L'art antérieur enseigne des systèmes intégrés comportant des zones de stockage temporaire des conteneurs, comportant des moyens de distribution de ces conteneurs entre une ligne d'alimentation de la travée en conteneurs, les emplacements de stockage et stockage temporaire, et les ouvertures de chargement/déchargement des outils disposés dans la travée.

On connaît par exemple un système comportant un stockage en tête de travée. Le transporteur inter-travée qui relie les travées pour l'alimentation de chacune d'elles en conteneurs, dépose et prend les conteneurs dans une unité de stockage à l'entrée de la travée, puis un transporteur interne à la travée saisit les conteneurs stationnant dans le stockage et les achemine sur les ouvertures de chargement/déchargement des outils de traitement ou bien dans des stockages tampons placés de manière saillante en face avant des outils, c'est à dire saillant en avant d'un plan défini par l'ouverture de chargement/déchargement des plaques. Dans le cas de la présence d'un stockage tampon en face avant de certains outils, un mécanisme d'alimentation interne à l'outil concerné permet le transport des conteneurs de la zone de stockage temporaire vers l'ouverture de chargement/déchargement et inversement car le transporteur interne à la travée ne peut plus agir compte tenu de l'encombrement provoqué par la zone de stockage temporaire en face avant gênant les mouvements du transporteur interne à la travée pour l'alimentation directe de l'ouverture de chargement/déchargement de l'outil. De manière alternative, un conteneur peut être directement transféré à partir du transporteur inter-travée sur le transporteur interne à la travée sans passer par le stockage en tête de travée, pour ensuite être acheminé sur les ouvertures de chargement/déchargement ou les zones de stockage temporaire, comme expliqué précédemment. Le transporteur interne à la travée peut être constitué d'un rail disposé au dessus des ouvertures de chargement/déchargement des outils, et d'un ascenseur combiné permettant de descendre un conteneur en suspension sur le rail en face d'une ouverture de chargement/déchargement d'outil ; dans ce cas, il est nécessaire que le trajet de descente ou de montée soit libre ce qui n'est pas le cas lorsque des zones de stockage sont disposées en face avant au dessus des ouvertures de chargement/déchargement, et de plus l'ascenseur ne peut saisir des conteneurs placés en face avant et au dessous d'une première rangée de conteneurs, d'où la nécessité d'un mécanisme supplémentaire spécifique souvent encombrant pour le transport des conteneurs situés dans les zones de stockage temporaires inférieures vers les ouvertures de chargement/déchargement.

Un tel agencement des zones de stockage induit une surface au sol importante et des moyens spécifiques pour tenir compte de l'implantation de ces zones de stockage temporaires, comme les mécanismes supplémentaires spécifiques d'alimentation en conteneurs. En outre, la complication des systèmes mécaniques de transport des conteneurs induit également des risques de pannes accrus et des surcoûts de gestion. La panne d'un mécanisme d'alimentation spécifique à un outil entraîne l'isolement de cet outil et l'impossibilité de l'alimenter en conteneurs. En outre, il y a lieu de rappeler que la surface au sol dans les unités de traitement des plaques de semi-conducteur est extrêmement onéreuse compte tenu des exigences de propreté appliquées.

On connaît le document US 5,980,183 qui propose une solution consistant à éliminer les zones de stockage et stockage temporaire conventionnelles en créant un espace additionnel à l'intérieur d'une travée d'outils sans augmenter la taille de cette travée. Le document US 5,980,183 propose en fait un système de stockage des conteneurs généralisé en face avant des outils de traitement et au dessus des ouvertures de chargement/déchargement, saillant de la face avant et du plan défini par les ouvertures de chargement/déchargement des plaques, et pouvant dépasser la hauteur des outils, remplaçant ainsi le stockage en tête de travée et les stockages temporaires en face avant affectés à un outil spécifique de l'art antérieur. Ce mode de stockage nécessite la présence d'une navette ayant accès aux étagères de stockage en face avant et d'une interface avec la ligne d'alimentation inter-travée en conteneurs. Cette navette est constituée d'un moyen de préhension des conteneurs mobiles en translation suivant deux axes perpendiculaires, se déplaçant dans le plan vertical en avant des étagères de stockage, donc dans un plan vertical placé devant les conteneurs stockés en face avant des outils. La navette permet de saisir les conteneurs déposés par la ligne d'alimentation inter-travée à l'entrée de la travée sur des étagères appropriées, et remplace donc le transporteur interne à la travée et le mécanisme de transport des conteneurs spécifique à chaque outil possédant un stockage tampon, de l'art antérieur, d'où une simplification importante des systèmes. Cependant, le stockage des conteneurs réalisé en face avant des outils, de manière saillante à celle-ci, demandant un mécanisme de transport placé encore en avant des conteneurs stockés ; de ce fait, un tel système de stockage réclame une projection au sol importante des installations, donc des coûts importants de fabrication et de fonctionnement. En outre, entre les étagères de stockage et le mécanisme de transport placé en avant et au dessus des ouvertures de chargement/déchargement, il existe un risque accru de pollution des ouvertures.

On connaît le document WO 99/02436 qui se rapporte à un système de stockage, distribution et récupération de conteneurs pour plaques de semi-conducteurs situés sur des étagères dans un plan arrière, le mécanisme de préhension et transport des conteneurs étant un système frontal à deux dimensions, disposé en avant des conteneurs situés dans le plan frontal des outils de traitement, et permettant aux conteneurs de rester dans le plan X-Z des étagères de stockage. Les étagères de stockage peuvent être situées dans le plan frontal des outils de traitement, ou sur le côté de ceux-ci. Les étagères de stockage peuvent s'étendre sur deux rangées ou plus en profondeur perpendiculairement au plan X-Z, au dessus de l'outil de traitement ; dans ce cas, le robot de manipulation peut comprendre des éléments télescopiques qui permettent d'atteindre les conteneurs les plus en arrière au dessus de l'outil de traitement. Ce document divulgue un système de stockage encombrant en terme de surface projetée au sol et ne divulgue pas de moyens de stockage temporaire des conteneurs.

On connaît en outre le document EP 1 079 421 qui se rapporte à un système de transport aérien de conteneurs pour plaques de semi-conducteurs, comportant un rail de guidage pour un véhicule de transport circulant sur celui-ci, et à partir duquel est suspendu un capot relié au dit véhicule au moyen d'un ascenseur, permettant de desservir un conteneur circulant sous le rail, sur une ouverture d'un outil de traitement pour un chargement/déchargement de plaques.

On connait également le document WO 00/37338 qui se rapporte à un système de transport et de stockage de conteneurs de plaques de semi conducteur. Ce système comprend des moyens de stockage des conteneurs dans un espace situé au dessus de l'outil de traitement des plaques de semi-conducteur ainsi que des moyens de transfert des conteneurs à partir des moyens de stockage vers des ouvertures de chargement/déchargement des plaques de semiconducteur, et inversement.

La présente invention vise à pallier ces inconvénients. Plus particulièrement, elle consiste en un système de transport et de stockage de conteneurs de plaques de semi-conducteur, destiné à être utilisé dans au moins une travée d'une fabrique de plaques de semi-conducteur, ladite au moins une travée comprenant un ou plusieurs outils de traitement des plaques de semi-conducteur, le ou lesdits outils de traitement comportant respectivement une face avant munie d'au moins une ouverture de chargement/déchargement des plaques de semi-conducteur apte à être associée à un conteneur de plaques de semi-conducteur, l'ensemble des ouvertures de chargement/déchargement des plaques du ou desdits outils de traitement étant sensiblement compris dans un plan vertical, ladite travée étant alimentée en conteneurs par un transporteur de travée situé au dessus du ou des outils de traitement et parallèle au dit plan vertical, caractérisé en ce que ledit système comprend,
- des moyens de stockage des conteneurs dans un espace situé au dessus dudit ou desdits outils de traitement des plaques de semi-conducteur et en retrait vers l'arrière desdites ouvertures de chargement/déchargement des plaques de semi-conducteur,
- des moyens de support temporaire d'au moins un conteneur, saillant en face avant des outils de traitement, situés à l'aplomb du transporteur de travée, apte à laisser libre l'espace sis au dessus desdites ouvertures de chargement/déchargement des plaques de semi-conducteur,
- des premiers moyens de transfert des conteneurs à partir desdits moyens de support temporaire vers lesdits moyens de stockage, et inversement,
- des deuxièmes moyens de transfert des conteneurs à partir desdits moyens de stockage vers lesdites ouvertures de chargement/déchargement des plaques de semi-conducteur, et inversement,
- des troisièmes moyens de transfert des conteneurs à partir desdits moyens de support temporaire vers lesdites ouvertures de chargement/déchargement des plaques de semi-conducteur, et inversement.

Selon une caractéristique avantageuse, lesdits moyens de stockage comprennent une pluralité d'étagères sises dans un volume situé dans son intégralité au dessus dudit ou desdits outils de traitement des plaques de semi-conducteur et en arrière desdites ouvertures de chargement/déchargement des plaques.

Selon une autre caractéristique avantageuse, lesdites étagères de stockage s'étendent sur la longueur de ladite au moins une travée, et sur plusieurs étages les unes au dessus des autres.

Selon une autre caractéristique avantageuse, lesdits moyens de stockage comprennent un châssis comportant :
- une partie supérieure à laquelle est fixée la pluralité d'étagères globalement en appui sur le châssis,
- un plancher sis au dessus du ou des outils de traitement des plaques de semi-conducteur, ledit plancher comportant une zone libre située le long des étagères et de la travée, permettant la libre circulation d'un opérateur,
- des piliers de soutien dudit plancher en appui sur le sol.

De manière alternative, lesdits moyens de stockage comprennent un châssis comportant :
- une partie supérieure à laquelle est fixée la pluralité d'étagères globalement en appui sur le châssis,
- un plancher sis au dessus des outils de traitement des plaques de semi-conducteur, ledit plancher comportant une zone libre située le long des étagères et de la travée permettant la libre circulation d'un opérateur,
- des moyens de suspension du plancher et de la partie supérieure en plafond dans la travée.
   Selon une autre caractéristique avantageuse, ledit plancher comporte des moyens pour permettre une circulation verticale d'air.
   Selon une autre caractéristique avantageuse, lesdits premiers, deuxièmes, et troisièmes moyens de transfert des conteneurs sont réunis dans un mécanisme de transfert comportant des moyens de préhension d'un conteneur, des moyens de déplacement desdits moyens de préhension dans les trois directions de l'espace, permettant aux dits moyens de préhension d'atteindre les ouvertures du ou des outils pour le chargement/déchargement des plaques, les étagères de stockage et les moyens de support temporaire.
   Selon une autre caractéristique avantageuse, lesdits moyens de déplacement des moyens de préhension présentent au moins trois degrés de liberté en translation suivant trois directions perpendiculaires X, Y, Z.
   Selon une autre caractéristique avantageuse, ledit mécanisme de transfert comprend des premiers moyens de guidage parallèles à la travée permettant d'obtenir un degré de liberté en translation suivant la direction X, des deuxièmes moyens de guidage permettant d'obtenir un degré de liberté en translation suivant la direction Z, un chariot portant les moyens de préhension et guidé en translation sur lesdits deuxièmes moyens de guidage, les moyens de préhension étant liés au dit chariot au moins par une liaison à un degré de liberté en translation suivant la direction Y.

Selon une autre caractéristique avantageuse, lesdits deuxièmes moyens de guidage sont libres en translation sur lesdits premiers moyens de guidage.

Selon une autre caractéristique avantageuse, lesdits premiers moyens de guidage possèdent une longueur sensiblement égale à la longueur de la travée, et lesdits deuxièmes moyens de guidage possèdent une hauteur sensiblement égale à la hauteur de la partie supérieure du châssis.

Selon une autre caractéristique avantageuse, lesdits premiers et deuxièmes moyens de guidage sont disposés en retrait vers l'arrière des ouvertures des outils dans un espace situé au dessus des outils de traitement des plaques de semi-conducteur, et en avant des étagères de stockage.

Selon une autre caractéristique avantageuse, lesdits moyens de préhension sont en outre liés au dit chariot par l'intermédiaire d'un système élévateur vertical conférant aux moyens de préhension une capacité à accéder dans une zone située au dessous dudit chariot.

Selon une autre caractéristique avantageuse, ladite liaison à un degré de liberté en translation suivant la direction Y entre les moyens de préhension et ledit chariot, est obtenue au moyen d'un dispositif permettant aux moyens de préhension un déplacement selon la direction Y de part et d'autre des premiers et deuxièmes moyens de guidage.

Selon une autre caractéristique avantageuse, le système selon l'invention comprend des moyens de déplacement desdits moyens de support temporaire de manière à permettre une libération de l'espace sis au dessus desdites ouvertures de chargement/déchargement des plaques de semi-conducteur.

Selon une autre caractéristique avantageuse, lesdits moyens de déplacement desdits moyens de support temporaire comprennent un degré de liberté en translation suivant l'axe Y, de sorte que lesdits moyens de stockage temporaire puissent se déplacer suivant l'axe Y entre une première position dite "position tirée" saillante en face avant et une deuxième position dite "position fermée", dans laquelle ledit moyen de support ne dépasse pas en face avant du ou des outils de traitement.

D'autres avantages et caractéristiques apparaîtront à la lecture de la description qui suit d'un exemple de mode de réalisation d'un système de transport et de stockage de conteneurs de plaques de semi-conducteur selon l'invention, accompagnée des dessins annexés, exemple cité à titre illustratif non limitatif, et dans lequel :
la figure 1 représente une vue en perspective de l'exemple de mode de réalisation d'un système selon l'invention,
la figure 2 représente une vue de face de l'exemple de la figure 1,
la figure 3 représente une vue de dessus de l'exemple de la figure 1,
la figure 4 représente une vue latérale de l'exemple de la figure 1,
la figure 5 représente en perspective un détail agrandi de l'exemple de la figure 1.

Les figures 6A et 6B représentent, dans deux positions de fonctionnement différentes, en vue de dessous et en perspective, un détail agrandi de la figure 5.

La figure 7 représente une vue schématique en coupe suivant l'axe Y du détail montré sur les figures 6A et 6B.

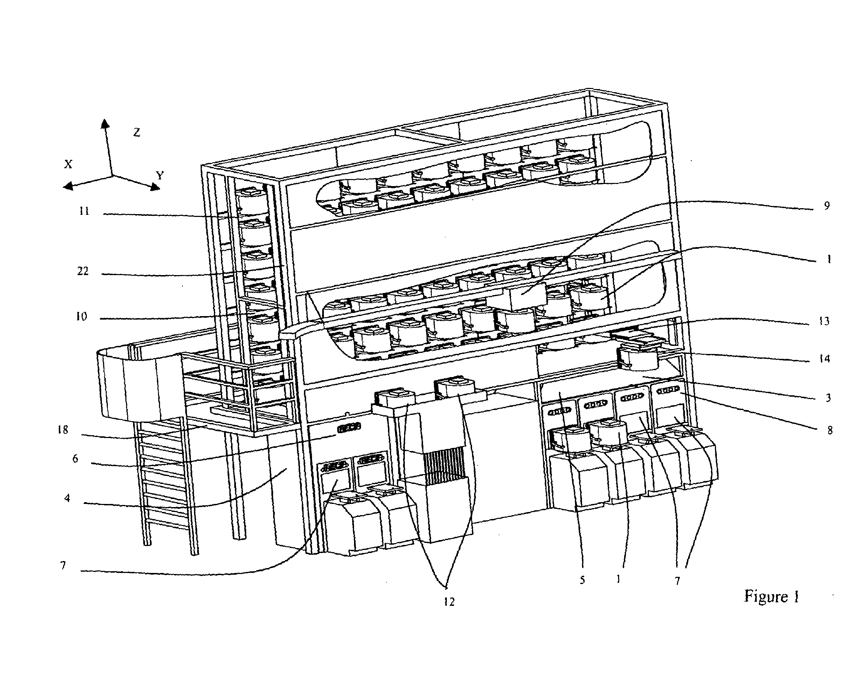

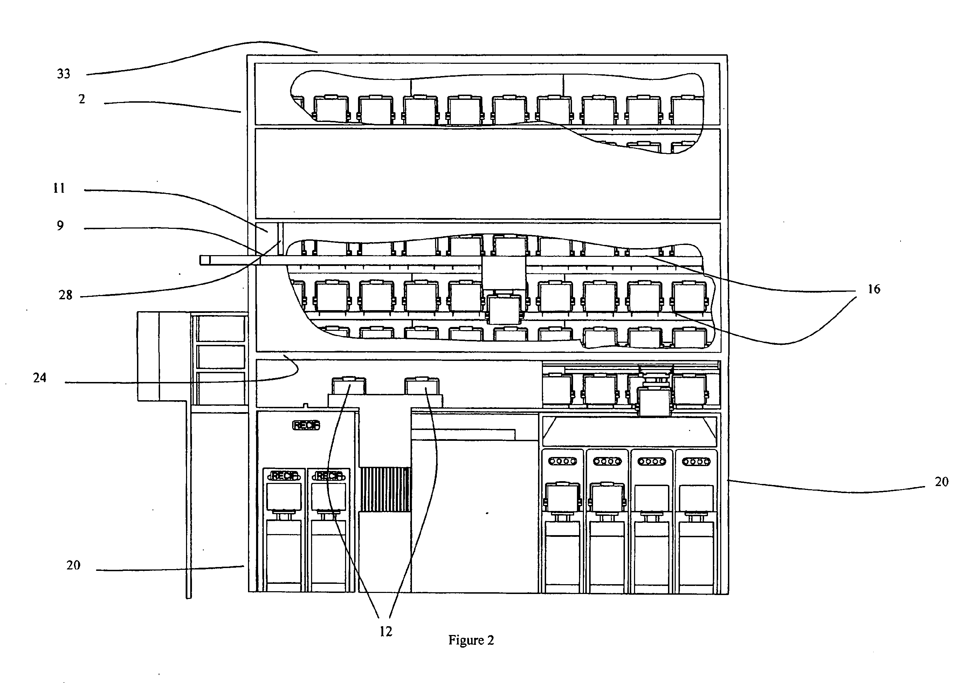

Le système représenté sur la figure 1 de transfert et de stockage de conteneurs 1 de plaques de semi-conducteur (non représentées), destiné à être utilisé dans au moins une travée 2 d'une fabrique de plaques de semi-conducteur, la travée représentée dans l'exemple comprenant par exemple quatre outils 3 sélecteur 300 mm pour traitement des plaques de semi-conducteur et deux outils 4 de caractérisation métrologique. Les outils 3, 4 de traitement des plaques comportent chacun des faces avant 5, 6 respectives, chaque face avant de chaque outil étant munie d'une ouverture 7 de chargement/déchargement des plaques de semi-conducteur apte à être associée à un conteneur 1 contenant une pluralité de plaques de semi-conducteur à traiter, l'ensemble des ouvertures de chargement/déchargement des plaques desdits outils de traitement étant sensiblement compris dans un plan vertical 8, la travée 2 étant alimentée en conteneurs par un transporteur 9 de travée situé au dessus des outils de traitement 3 et 4 et parallèle au plan vertical 8, tel que représenté sur la figure 1, 3 ou 4. Le système représenté sur les figures 1 à 7 comprend en outre,
- des moyens de stockage 10 des conteneurs 1 dans un espace 11 situé au dessus des outils 3 et 4 de traitement des plaques de semi-conducteur et en retrait des ouvertures 7 de chargement/déchargement des plaques de semi-conducteur, et vers l'arrière de ces ouvertures, plus particulièrement en retrait du plan vertical comprenant les ouvertures de chargement/déchargement, et vers l'arrière de ce plan vertical, la figure 1 représentant le système vue de l'avant,
- des moyens de support temporaire 12 de deux conteneurs 1, notamment respectivement un moyen de support pour l'entrée et un autre pour la sortie d'un conteneur des moyens de stockage, saillant en face avant 5, 6 des outils 3, 4 de traitement, situés à l'aplomb du transporteur 9 de travée et dans l'exemple latéralement décalés des ouvertures 7 de chargement/déchargement des plaques de semi-conducteur placées sur les outils de traitement, de manière à laisser libre l'espace sis au dessus des ouvertures 7 de chargement/déchargement des plaques de semi-conducteur,
- des premiers moyens de transfert 13 des conteneurs 1 à partir des moyens de support temporaire 12 vers les moyens de stockage 10, et inversement,
- des deuxièmes moyens de transfert 13 des conteneurs 1 à partir des moyens de stockage 10 vers les ouvertures 7 de chargement/déchargement des plaques de semi-conducteur, et inversement,
- des troisièmes moyens de transfert 13 des conteneurs 1 à partir des moyens de support temporaire 12 vers les ouvertures 7 de chargement/déchargement des plaques de semi-conducteur, et inversement.

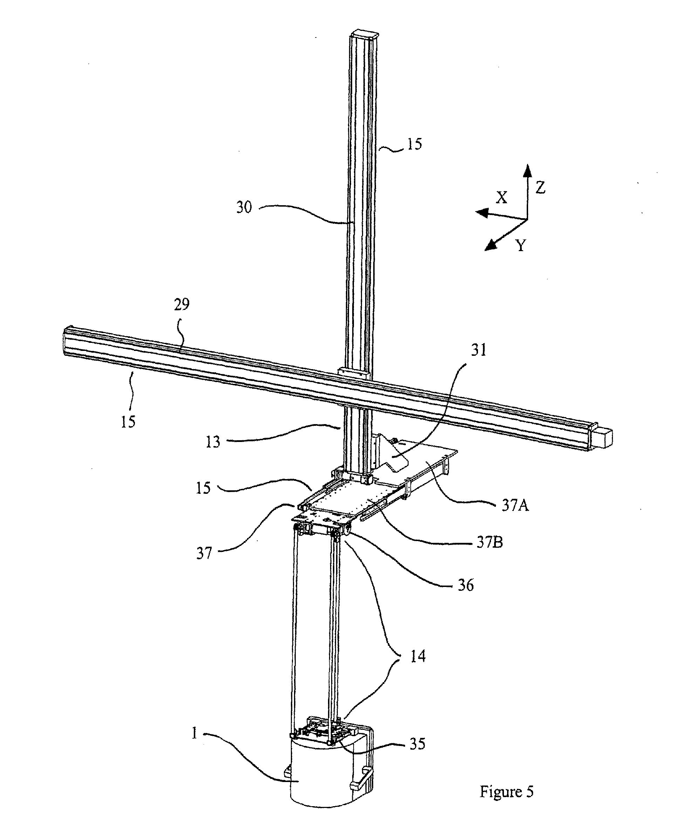

Comme plus particulièrement représenté sur les figures 5 à 7, les premiers, deuxièmes, et troisièmes moyens de transfert des conteneurs 1 sont réunis dans un mécanisme de transfert 13 comportant des moyens de préhension 14 d'un conteneur 1, des moyens de déplacement 15 des moyens de préhension 14 dans les trois directions X, Y, Z de l'espace permettant à ces moyens de préhension 14 d'atteindre les ouvertures 7 des outils 3, 4 pour le chargement/déchargement des plaques, les étagères de stockage 16 et les moyens de support temporaire 12. Le mécanisme de transfert 13 sera décrit de manière plus détaillé plus loin.

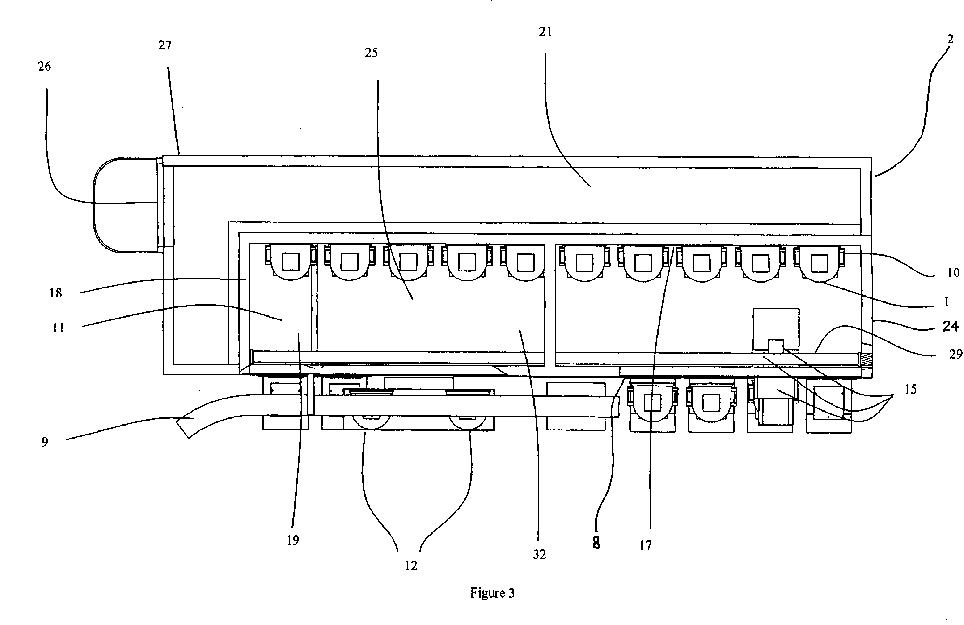

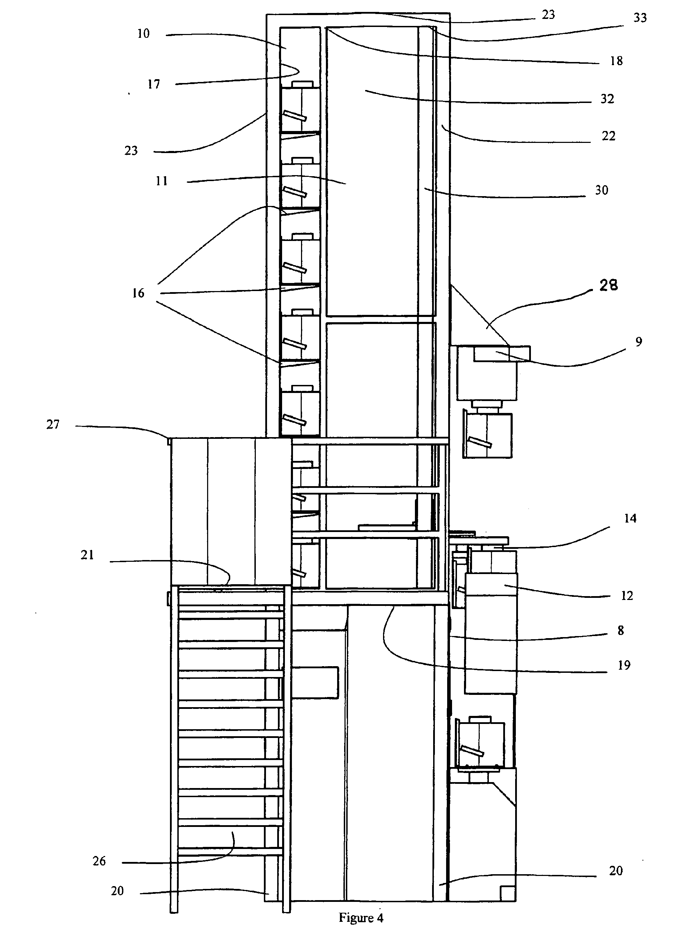

Les moyens de stockage 10 comprennent une pluralité d'étagères 16 sises dans un volume situé dans son intégralité au dessus des outils 3, 4 de traitement des plaques de semi-conducteur et en arrière des ouvertures 7 de chargement/déchargement des plaques. Comme représenté sur les figures 3 et 4, les étagères 16 permettent de stocker des conteneurs 1 sensiblement contre un plan vertical 17 en retrait du plan vertical 8 comprenant les ouvertures 7 d'une distance supérieure à la dimension suivant l'axe Y des conteneurs 1, que l'on qualifiera de largeur du conteneur 1. La pluralité d'étagères 16 comprend par exemple quatre niveaux ou étages horizontaux superposés qui s'étendent sensiblement de préférence sur la longueur de la travée 2 afin d'utiliser un maximum d'espace disponible. Chaque étagère constituant un niveau peut être continue ou discontinue, et permet, dans l'exemple, d'aligner neuf conteneurs 1. La quantité de conteneurs alignés sur un niveau dépend de la longueur de la travée, elle même conditionnée par le nombre d'outils de traitement en place dans une travée. La hauteur de stockage suivant la direction Z n'est limitée que par l'espace disponible au dessus des outils. On peut envisager de construire un nombre de niveaux d'étagères supérieur, allant jusqu'à la hauteur maximale admissible en fonction de la construction abritant la travée. Les étagères doivent permettre un accès libre frontal à chacun des conteneurs stockés indépendamment des autres conteneurs stockés, plus particulièrement permettre un accès aux moyens de préhension 14 à chaque partie supérieure des conteneurs 1 par laquelle le conteneur est saisi. De ce fait, la hauteur séparant deux étagères superposées doit être suffisante pour laisser pénétrer entre ces étagères les moyens de préhension 14 et un conteneur 1 associés à ces derniers, permettre la libération et la saisie ou prise d'un conteneur.

Les moyens de stockage 10 comprennent un châssis 18 comportant un plancher 19 sis au dessus des outils de traitement 3, 4 des plaques de semi-conducteur, des piliers 20 de soutien du plancher 19 en appui sur le sol, et une partie supérieure à laquelle est fixée la pluralité d'étagères 16 globalement en appui sur le châssis 18.

Le plancher 19 pris dans son armature, les piliers 20 et la partie supérieure 22 du châssis 18 sont réalisés par exemple en profilés tubulaires métalliques mécano-soudés. Le plancher 19 lui-même est réalisé en plaques avantageusement perforées ou ajourées afin de lui permettre d'être traversée par une circulation verticale d'air, et comporte avantageusement une zone libre 21 située le long des étagères 16 et de la travée 2 à l'arrière du plan 17 d'appui des étagères 16, comme représenté sur les figures 3 et 4, permettant la libre circulation d'un opérateur. Le châssis 18 sera conçu et fabriqué en appliquant les règles connues de la construction mécanique, afin qu'il puisse supporter au moins son propre poids, celui du mécanisme de transfert 13 et des moyens de support temporaire 12, celui d'un nombre de conteneurs remplis de plaques égal aux possibilités de stockage et support des conteneurs, ainsi que le poids d'au moins un opérateur dans la zone libre 21. La zone libre 21 comportera de préférence un accès vertical, obtenu par exemple au moyen d'une échelle 26, et des moyens de barrières de protection 27, comme représenté sur les figures 3 et 4.

La partie supérieure 22 du châssis 18 qui fournit une structure de soutien aux étagères 16 et au mécanisme de transfert 13, comme plus particulièrement représenté sur la figure 1, pourra adopter la forme d'une ossature parallélépipédique ouverte formée par les arêtes 23 du parallélépipède et des barres 24 de renfort intermédiaires verticales et/ou horizontales ne gênant pas l'accès aux étagères 16. Les côtés du parallélépipède qui ne sont pas utilisés pour accéder aux conteneurs 1 stockés, soit les côtés d'extrémité 24 de la travée 2, et le dessus 25 pourront être fermés par des plaques de protection.

Les outils de traitement 3, 4 des plaques sont placés dans la travée 2 entre les piliers 20 du châssis 18 et sous le plancher 19, comme représenté sur la figure 1, la face avant des outils comportant les ouvertures 7 étant positionnée dans le plan vertical 8 sensiblement défini par les piliers 20 et les arêtes 23 verticales du parallélépipède constituant la partie supérieure 22 du châssis 18, pris dans leurs faces extérieures.

Le châssis 18 devra également être apte à supporter le transporteur 9 de travée situé au dessus des outils de traitement 3 et 4 et parallèle au plan vertical 8, au moyen d'une ou plusieurs potences d'accrochage 28 du transporteur 9, fixée de préférence à une ou plusieurs arêtes verticales de la partie supérieure 22 du châssis 18.

De manière alternative et selon les besoins, le plancher 19 et la partie supérieure 22 pourront être suspendus en plafond au lieu d'être en appui sur le sol, grâce à des moyens de suspension de tout type connu (non représentés), par exemple aux moyens de chevilles appropriées et de vis de fixation de l'ensemble plancher 19 et partie supérieure 22 au plafond de la travée. Une telle configuration peut être avantageuse afin de minimiser l'interaction entre la structure porteuse du système et les équipements placés sur le sol.

Les moyens de support temporaire sont constitués de deux étagères 12 fixées contre le plan vertical 8 sur le châssis 18, de préférence sensiblement au niveau du plancher 19, et saillant vers l'avant comme représenté sur la figure 1. Les étagères 12 sont horizontales et possèdent chacune une surface correspondant au plus et sensiblement à la surface de base d'un conteneur 1, afin de réduire l'encombrement induit par ces moyens de support temporaire. Un support 12 est affecté à la réception des conteneurs qui proviennent du transporteur 9 de travée, l'autre support 12 étant affecté au départ des conteneurs sur le transporteur de travée. Il est à noter que l'affectation départ ou arrivée pour chaque support 12 peut être indifféremment inversée. De manière alternative, dans le cas d'un système de stockage de faible longueur suivant la direction X, par exemple un système comportant un seul ou peu d'outils, les moyens de support temporaire pourront avantageusement être constitués chacun d'un tiroir extractible suivant l'axe Y, selon tout moyen connu de type tiroir extractible, c'est à dire perpendiculairement au plan vertical 8 comprenant les ouvertures 7. Le système de stockage comportera un moyen de déplacement de chaque tiroir extractible, par exemple un tiroir motorisé, de manière que ce dernier puisse adopter une première position dite "position tirée" saillante en face avant comme représenté sur la figure 1, et une deuxième position dite "position fermée" (non représentée), dans laquelle le moyen de support temporaire 12 ne dépasse pas en face avant 5, 6 du ou des outils de traitement 3, 4 et ne gêne donc pas l'accès des ouvertures 7 par le dessus pour le mécanisme de transfert si ce support temporaire 12 est placé au dessus de celle-ci.

Le mécanisme de transfert va maintenant être plus particulièrement décrit avec l'aide des figures 5 à 7. Comme représenté plus particulièrement sur la figure 5, les moyens de déplacement 15 des moyens de préhension 14 présentent trois degrés de liberté en translation suivant les trois directions perpendiculaires X, Y, Z de l'espace. Le mécanisme de transfert 13 à cet effet comprend :
- des premiers moyens 29 de guidage parallèles à la travée 2, fixés au châssis 18 et conférant aux moyens de préhension 14 un degré de liberté en translation suivant la direction X,
- des deuxièmes moyens 30 de guidage liés aux premiers moyens de guidage 29 et libres en translation sur ces derniers, conférant aux moyens de préhension 14 un degré de liberté en translation suivant la direction Z,
- un chariot 31 portant les moyens de préhension 14, lié aux deuxièmes moyens 30 de guidage et libre en translation sur ces derniers,
- des moyens de préhension 14 qui sont liés au chariot 31 par une liaison à un degré de liberté en translation suivant la direction Y, et un degré de liberté en translation suivant l'axe Z au moyen d'un système élévateur 36 vertical conférant aux moyens de préhension 14 une capacité à accéder dans une zone située au dessous dudit chariot et notamment au dessous de la limite inférieure des deuxièmes moyens de guidage 30.

De manière alternative, les deuxièmes moyens 30 de guidage conférant aux moyens de préhension 14 un degré de liberté en translation suivant la direction Z peuvent être directement liés au châssis 18, les premiers moyens 29 de guidage conférant aux moyens de préhension 14 un degré de liberté en translation suivant la direction X étant alors montés libres en translation le long des deuxièmes moyens de guidage (non représenté).

Les premiers moyens 29 de guidage possèdent une longueur sensiblement égale à la longueur de la travée 2, les deuxièmes moyens 30 de guidage possèdent une hauteur sensiblement égale à la hauteur de la partie supérieure 22 du châssis 18, afin que le déplacement du chariot 31 suivant les directions X et Z couvre l'accès, pour les moyens de préhension, à l'ensemble des étagères 16 de stockage. Les premiers 29 et deuxièmes 30 moyens de guidage adoptent avantageusement et respectivement la forme de rails prismatiques et sont disposés en retrait des ouvertures 7 des outils 3, 4 et du plan vertical 8 qui les inclut, dans un espace 32 situé au dessus des outils 3, 4 de traitement des plaques de semi-conducteur, et en avant des étagères 16.

Dans l'exemple représenté sur la figure 5, les deux rails prismatiques 29 constituant les premiers moyens de guidage sont fixés rigidement respectivement et sensiblement au niveau du sommet 33 et un peu au dessus du plancher 19 du châssis 18, de manière horizontale. En effet, dans la configuration représentée sur la figure 5, qui comprend un rail unique vertical 30 comme deuxièmes moyens de guidage, il doit exister entre le plancher 19 et le rail 29 horizontal inférieur une distance suffisante pour le passage d'un conteneur 1 de part et d'autre du plan 8 vertical et sous le rail 29 horizontal inférieur.

les deuxièmes moyens de guidage, constitués d'un ou deux (non représenté) rails 30 prismatiques, sont maintenus verticaux et parallèles de manière rigide, adoptant ainsi la forme d'un cadre dans le cas de deux rails, le ou les rails 30 étant guidés en translation sur les rails 29 horizontaux par leurs extrémités selon tous moyens connus, par exemple par des liaisons à roulement. Le chariot 31 adopte la forme d'une structure rigide guidée en translation sur le ou les rails 30 verticaux par tous moyens connus, par exemple une liaison à roulement. Le déplacement selon l'axe X sur les rails horizontaux 29 du ou des rails 30 verticaux est avantageusement obtenu selon tout moyen connu, par exemple au moyen d'un moteur linéaire (non représenté), et le déplacement du chariot 31 sur le ou les rails verticaux 30 selon l'axe Z est avantageusement obtenu également selon tout moyen connu, par exemple au moyen d'un servomoteur et d'une transmission à courroie (non représentés).

Comme on le constate sur l'exemple représenté sur la figure 5, dans le cas d'utilisation d'un rail 30 vertical unique, le déplacement selon l'axe Y des moyens de préhension 14 n'est possible que lorsque le chariot 31 est en position basse à l'extrémité inférieure du rail vertical 30. En effet, à cet endroit, le dispositif télescopique 37 peut agir selon l'axe Y de part et d'autre des rails 29 et 30 sans être gêné par ces derniers. Si l'on désire un déplacement des moyens de préhension 14 de part et d'autre des rails 29, 30 en tout endroit des étagères de stockage 16, il est nécessaire d'utiliser deux rails verticaux 30 reliés par un chariot 31 portant les moyens de préhension 14, l'écartement entre les deux rails verticaux étant supérieur à la largeur d'un conteneur 1. Ainsi, le dispositif télescopique 37 agit entre les deux rails verticaux entre lesquels doit passer le conteneur 1, son déplacement n'étant plus entravé par ce ou ces derniers. Les rails horizontaux 29 sont placés de sorte qu'ils n'entravent pas le déplacement du dispositif télescopique 37 aux endroits d'intérêt.

Les moyens de préhension 14 sont constitués d'une pince 35 standard, appropriée pour saisir un conteneur 1 par sa partie supérieure, et d'un système élévateur 36 permettant de déplacer la pince 35 suivant l'axe Z, la pince 35 et le système élévateur étant liés au chariot 31 par l'intermédiaire de tous moyens permettant un degré de liberté suivant l'axe Y, par exemple un dispositif télescopique 37 conférant à la pince 35 et au système élévateur 36 un degré de liberté suivant l'axe Y, comme représenté sur les figures 5, 6A, 6B, et 7. Il est à noter que le dispositif télescopique 37 permet, lorsque qu'un conteneur 1 est présent sur la pince 35 et que cette dernière est amenée en position haute, la pince 35 contre le dispositif télescopique 37, de déplacer le conteneur 1 suivant l'axe Y de part et d'autre des rails 30 comme indiqué précédemment. Lorsque le dispositif télescopique 37 est en arrière des rails 30, les moyens de préhension 14 peuvent poser ou prendre un conteneur placé sur une étagère 16. Lorsque le dispositif télescopique 37 est en avant des rails 30, les moyens de préhension peuvent poser ou prendre un conteneur 1 placé sur une ouverture de chargement/déchargement 7 ou un moyen de stockage temporaire 12.

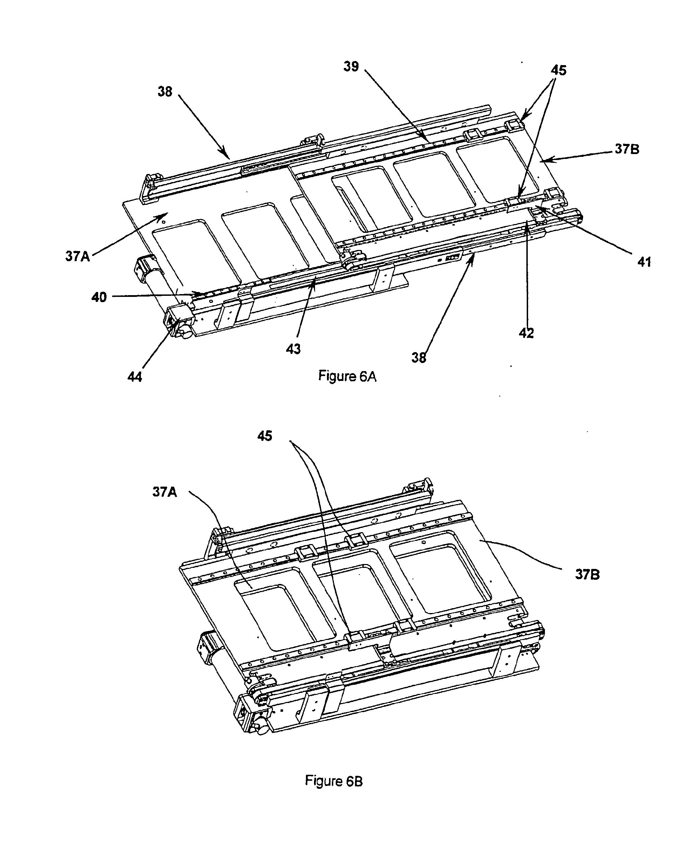

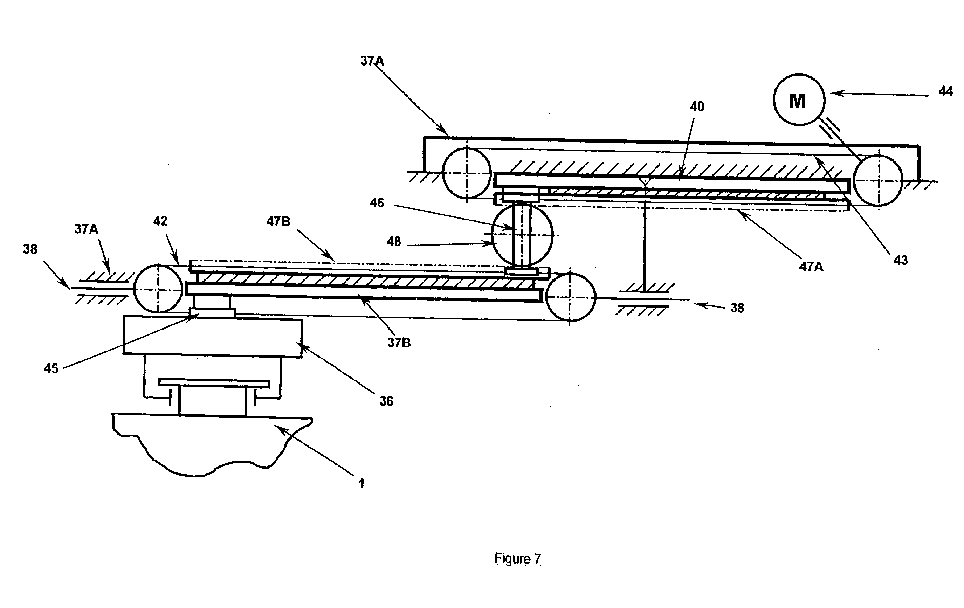

Le dispositif télescopique 37 est un système fonctionnant à base de mouvements de translation suivant l'axe Y, et peut par exemple être constitué de deux plaques 37A et 37B reliées par des rails de guidage télescopiques 38 pouvant se déployer dans les deux directions Y+ et Y-, de rails de guidage 39 fixés sur la plaque 37B supportant un ou des patins 45 sur lesquels les moyens de préhension 14 sont fixés, et plus particulièrement le système élévateur 36 des moyens de préhension 14, comme représenté sur les figures 5, 6A et 6B. La plaque 37A est fixée sur les moyens de déplacement 15, plus particulièrement sur le chariot 31. La plaque 37B est déplacée par rapport à la plaque 37A à l'aide d'une roue dentée 48 se déplaçant sur des crémaillères 47A et 47B, comme représenté sur la figure 7. L'axe de la roue dentée 48 est entraîné par une première courroie 43 de façon que le déplacement de la plaque 37B soit deux fois plus important que celui de la roue dentée 48. Les patins 45 sont déplacés selon l'axe Y par rapport à la plaque 37B à l'aide d'une première pièce d'interface 41 solidaire d'une deuxième courroie 42 elle-même connectée à la première courroie 43 par une deuxième pièce d'interface 46 guidée en translation sur des rails 40 fixés sur la plaque 37A, comme représenté sur la figure 7. Un moteur 44 entraîne en rotation la courroie 43 et permet ainsi d'obtenir le déplacement de la pince 35 et du système élévateur 36 selon l'axe Y, à la verticale des ouvertures de chargement/déchargement 7, à la verticale des étagères 16, ou en position intermédiaire dans laquelle le dispositif télescopique 37 supportant éventuellement un conteneur 1 est particulièrement compact selon l'axe Y, les les plaques 37A et 37B étant superposées l'une sur l'autre et les patins 45 se trouvant au centre des plaques suivant la direction Y. Dans cette position intermédiaire, le dispositif télescopique 37 est suffisamment compact pour permettre son déplacement à l'intérieur du châssis 22 entre les étagères 16 et le plan 8 à l'aplomb des ouvertures chargement/déchargement 7, et en position dépliée il peut atteindre à la fois la verticale des étagères 16 et la position nécessaire pour desservir les ouvertures de chargement/déchargement 7. Il est à noter que l'entraînement à l'aide de crémaillères peut notamment être remplacé par une courroie supplémentaire (non représenté).

Sur la figure 5, le dispositif télescopique 37 suivant l'axe Y a été représenté dans la position déployée, ainsi que sur la figure 6A, et sur la figure 6B le même dispositif télescopique a été représenté en position intermédiaire telle que décrite ci-dessus. Sur la figure 7, le dispositif télescopique a été représenté dans la position déployée.

Le système élévateur 36 suivant l'axe Z peut être obtenu par tous moyens et notamment un moyen d'ascenseur à câbles comme représenté sur la figure 5. On remarquera que le mécanisme de transfert 13 via le système élévateur 36 possède, lorsque la pince 35 est placée à l'aplomb des ouvertures 7 des outils 3, 4, une fonction similaire à celle du transporteur de travée 9 qui permet grâce à son ascenseur (non représenté) notamment le dépôt ou la prise d'un conteneur 1 sur ces mêmes ouvertures. Le mécanisme de transfert 13 peut ainsi effectuer des taches confiés antérieurement au transporteur de travée 9. Un tel système confère une grande souplesse au dispositif selon l'invention, et un gain de temps appréciable, car les déplacements des conteneurs 1 au moyen du mécanisme de transfert 13 peuvent être plus rapides que les déplacements des conteneurs 1 effectués au moyen du transporteur de travée 9.

Le système de transport et de stockage de conteneurs 1 de plaques de semi-conducteur, est géré par un ordinateur central (non représenté) comportant un logiciel de pilotage du système et servant d'interface pour un opérateur, et autorisant un pilotage déterminé du mécanisme de transfert en fonction des besoins des outils de traitement des plaques, c'est à dire une commande du déplacement et de l'actionnement des moyens de préhension, soit des dispositifs moteurs correspondants, dans les trois directions X, Y, Z. Le système comprend à cet effet des capteurs de présence (non représentés) de conteneurs sur chaque emplacement de stockage ou de support des conteneurs, afin de connaître à tout moment les emplacements disponibles et occupés. Le système peut bien entendu fonctionner de manière automatique, à partir d'un logiciel de programmation du pilotage du système, adapté en fonction des besoins.

Le système de transport et de stockage de conteneurs 1 de plaques de semi-conducteur tel que représenté sur les figures fonctionne de la manière suivante:

Le transporteur de travée 9 alimente la travée en conteneurs 1. Le transporteur dépose les conteneurs un par un sur un support 12 d'arrivée, ou directement sur les ouvertures des outils placées à l'aplomb de l'ascenseur (non représenté) du transporteur 9 de travée.

Si le conteneur est déposé sur le support 12 d'arrivée, ce conteneur est ensuite saisi par les moyens de préhension 14 du mécanisme de transfert 13, qui viennent se placer au dessus du conteneur grâce aux déplacements en X, Y, et Z, puis saisissent le conteneur pour être acheminé et déposé sur un emplacement de stockage sur les étagères 16, en attente d'être affecté à un outil de traitement spécifique, grâce aux déplacements en X, Y, et Z et au système élévateur 36 du mécanisme de transfert. Le support d'arrivée est ainsi libéré pour recevoir un autre conteneur du transporteur de travée. Le conteneur ainsi stocké sur les étagères 16 est ensuite, lorsque l'outil de traitement vers lequel le conteneur est destiné le permet, saisi à nouveau par les moyens de préhension 14 puis acheminé et déposé sur l'ouverture 7 de l'outil de destination, aux moyens des déplacements en X, Y, Z du mécanisme de transfert, et du système élévateur 36 de ce dernier qui descend la pince 35 et le conteneur sur l'ouverture 7 de l'outil de destination. De manière alternative le conteneur déposé sur le support 12 d'arrivée par le transporteur de travée 9 peut être ensuite saisi et directement acheminé sur une ouverture d'outil de destination, puis, de cette ouverture, ramené sur le support 12 de départ ou acheminé sur un emplacement de stockage sur les étagères 16.

Si le conteneur est déposé directement sur une ouverture d'outil à partir du transporteur de travée, ce conteneur, une fois les plaques de semi-conducteur traitées dans l'outil, peut être directement repris par le transporteur de travée ou saisi et acheminé par le mécanisme de transfert vers un emplacement de stockage sur les étagères 16 ou sur le support 12 de départ, aux moyens des déplacements en X, Y, Z du mécanisme de transfert, et du système élévateur 36 de ce dernier qui remonte la pince 35 et le conteneur à partir de l'ouverture 7 de l'outil, afin que ce conteneur soit placé en attente d'une autre affectation d'outil dans la travée, ou d'une saisie par le transporteur de travée, respectivement.

Il est à noter que la structure du système décrit à l'aide des figures 1 à 5 permet aux moyens de préhension 14 du mécanisme de transfert 13 d'atteindre physiquement un conteneur placé à tout endroit du système pouvant supporter un conteneur, c'est à dire d'atteindre les étagères de stockage 16 au dessus et en arrière des ouvertures des outils, les supports de départ et d'arrivée 12, les ouvertures 7 des outils de la travée, et de déplacer un conteneur se trouvant dans n'importe lequel de ces endroits vers n'importe lequel autre de ces endroits. Cependant, le logiciel de pilotage du système chargé dans l'ordinateur central peut limiter selon les besoins, en fonction notamment du type d'outil présent dans la travée, les déplacements des moyens de préhension vers certains seulement de ces endroits, excluant par exemple les supports 12, et réserver ces derniers à une accessibilité pour le transporteur de travée uniquement.

## Revendications

1. Système de transport et de stockage de conteneurs (1) de plaques de semi-conducteur, destiné à être utilisé dans au moins une travée (2) d'une fabrique de plaques de semi-conducteur, ladite au moins une travée comprenant un ou plusieurs outils (3, 4) de traitement des plaques de semi-conducteur, le ou lesdits outils de traitement comportant respectivement une face avant (5, 6) munie d'au moins une ouverture (7) de chargement/déchargement des plaques de semi-conducteur apte à être associée à un conteneur (1) de plaques de semi-conducteur, l'ensemble des ouvertures de chargement/déchargement des plaques du ou desdits outils de traitement étant sensiblement compris dans un plan vertical (8), ladite travée étant alimentée en conteneurs par un transporteur de travée (9) situé au dessus du ou des outils de traitement et parallèle au dit plan vertical,
**caractérisé en ce que** ledit système comprend:
- des moyens de stockage (10) des conteneurs dans un espace (11) situé au dessus dudit ou desdits outils de traitement des plaques de semi-conducteur et en retrait vers l'arrière desdites ouvertures de chargement/déchargement des plaques de semi-conducteur,
- des moyens de support temporaire (12) d'au moins un conteneur, saillant en face avant (5, 6) du ou des outils de traitement (3, 4), situés à l'aplomb du transporteur de travée (9) apte à laisser libre l'espace sis au dessus desdites ouvertures (7) de chargement/déchargement des plaques de semi-conducteur,
- des premiers moyens de transfert (13) des conteneurs (1) à partir desdits moyens de support temporaire (12) vers lesdits moyens de stockage (10), et inversement,
- des deuxièmes moyens de transfert (13) des conteneurs (1) à partir desdits moyens de stockage (10) vers lesdites ouvertures (7) de chargement/déchargement des plaques de semi-conducteur, et inversement,
- des troisièmes moyens de transfert (13) des conteneurs à partir desdits moyens de support temporaire (12) vers lesdites ouvertures (7) de chargement/déchargement des plaques de semi-conducteur, et inversement.

2. Système selon la revendication 1, ***caractérisé en ce que*** lesdits moyens de stockage (10) comprennent une pluralité d'étagères (16) sises dans un volume situé dans son intégralité au dessus dudit ou desdits outils de traitement (3, 4) des plaques de semi-conducteur et en arrière desdites ouvertures (7) de chargement/déchargement des plaques.

3. Système selon la revendication 2, ***caractérisé en ce que*** lesdites étagères (16) de stockage s'étendent sur la longueur de ladite au moins une travée (2), et sur plusieurs étages les unes au dessus des autres.

4. Système selon la revendication 2 ou 3, ***caractérisé en ce que*** lesdits moyens de stockage (10) comprennent un châssis (18) comportant :
- une partie supérieure (22) à laquelle est fixée la pluralité d'étagères (16) globalement en appui sur le châssis (18),
- un plancher (19) sis au dessus des outils de traitement (3, 4) des plaques de semi-conducteur, ledit plancher comportant une zone libre située le long des étagères et de la travée, permettant la libre circulation d'un opérateur,
- des piliers (20) de soutien dudit plancher en appui sur le sol.

5. Système selon la revendication 2 ou 3, ***caractérisé en ce que*** lesdits moyens de stockage (10) comprennent un châssis (18) comportant :
- une partie supérieure (22) à laquelle est fixée la pluralité d'étagères (16) globalement en appui sur le châssis (18),
- un plancher (19) sis au dessus des outils de traitement (3, 4) des plaques de semi-conducteur, ledit plancher comportant une zone libre située le long des étagères et de la travée permettant la libre circulation d'un opérateur,
- des moyens de suspension du plancher et de la partie supérieure en plafond dans la travée.

6. Système selon la revendication 4 ou 5, ***caractérisé en ce que*** ledit plancher (19) comporte des moyens pour permettre une circulation verticale d'air.

7. Système selon l'une quelconque des revendications 2 à 6, ***caractérisé en ce que*** lesdits premiers, deuxièmes, et troisièmes moyens de transfert des conteneurs sont réunis dans un mécanisme de transfert (13) comportant des moyens de préhension (14) d'un conteneur (1), des moyens de déplacement (15) desdits moyens de préhension dans les trois directions de l'espace, permettant aux dits moyens de préhension d'atteindre les ouvertures (7) du ou des outils (3, 4) pour le chargement/déchargement des plaques, les étagères (16) de stockage et les moyens de support temporaire (12).

8. Système selon la revendication 7, ***caractérisé en ce que*** lesdits moyens de déplacement (15) des moyens de préhension (14) présentent au moins trois degrés de liberté en translation suivant trois directions perpendiculaires X, Y, Z.

9. Système selon la revendication 8, ***caractérisé en ce que*** ledit mécanisme de transfert (13) comprend des premiers moyens (29) de guidage parallèles à la travée (2) permettant d'obtenir un degré de liberté en translation suivant la direction X, des deuxièmes moyens (30) de guidage permettant d'obtenir un degré de liberté en translation suivant la direction Z, un chariot (31) portant les moyens de préhension (14) et guidé en translation sur lesdits premiers (29) ou deuxièmes (30) moyens de guidage, les moyens de préhension étant liés au dit chariot par au moins une liaison à un degré de liberté en translation suivant la direction Y.

10. Système selon la revendication 9, ***caractérisé en ce que*** lesdits deuxièmes moyens (30) de guidage sont libres en translation sur lesdits premiers moyens (29) de guidage.

11. Système selon la revendication 9 ou 10, ***caractérisé en ce que*** lesdits premiers moyens de guidage (29) possèdent une longueur sensiblement égale à la longueur de la travée (2), **en ce que** lesdits deuxièmes moyens de guidage (30) possèdent une hauteur sensiblement égale à la hauteur de la partie supérieure (22) du châssis (18).

12. Système selon l'une des revendications 9 à 11, ***caractérisé en ce que*** lesdits premiers (29) et deuxièmes (30) moyens de guidage sont disposés en retrait vers l'arrière des ouvertures (7) du ou des outils (3, 4) dans un espace situé au dessus du ou des outils de traitement des plaques de semi-conducteur, et en avant des étagères (16) de stockage.

13. Système selon la revendication 12, ***caractérisé en ce que*** lesdits moyens de préhension (14) sont en outre liés au dit chariot (31) par l'intermédiaire d'un système élévateur (36) vertical conférant aux moyens de préhension une capacité à accéder dans une zone située au dessous dudit chariot.

14. Système selon l'une quelconque des revendications 9 à 13, ***caractérisé en ce que*** ladite liaison à un degré de liberté en translation suivant la direction Y entre les moyens de préhension (14) et ledit chariot (31), est obtenue au moyen d'un dispositif (37) permettant aux moyens de préhension un déplacement selon la direction Y de part et d'autre des premiers (29) et deuxièmes moyens (30) de guidage.

15. Système selon l'une quelconque des revendications 1 à 14, ***caractérisé en ce qu'**il* comprend des moyens de déplacement desdits moyens de support temporaire (12) de manière à permettre une libération de l'espace sis au dessus desdites ouvertures (7) de chargement/déchargement des plaques de semi-conducteur.

16. Système selon la revendication 15, ***caractérisé en ce que*** lesdits moyens de déplacement desdits moyens de support temporaire (12) comprennent un degré de liberté en translation suivant l'axe Y, de sorte que lesdits moyens de stockage temporaire puissent se déplacer suivant l'axe Y entre une première position dite "position tirée" saillante en face avant et une deuxième position dite "position fermée", dans laquelle ledit moyen de support (12) ne dépasse pas en face avant (5, 6) du ou des outils de traitement (3, 4).

## Claims

1. System for transporting and storing semiconductor wafer containers (1), designed to be used in at least one row (2) of a semiconductor wafer factory, said at least one row comprising one or more semiconductor wafer processing tools (3, 4), said processing tool or tools respectively comprising a front panel (5, 6) provided with at least one opening (7) for loading/unloading the semiconductor wafers, suitable for association with a semiconductor wafer container (1), the set of openings for loading/unloading the wafers of said processing tool or tools being roughly included in a vertical plane (8), said row being supplied with containers by a row transporter (9) located above the processing tool or tools and parallel to said vertical plane,
**characterized in that** said system comprises:
- means (10) of storing containers in a space (11) located above said semiconductor wafer processing tool or tools and set back towards the rear of said openings for loading/unloading the semiconductor wafers,
- means (12) of temporarily supporting at least one container, projecting on the front panel (5, 6) of the processing tool or tools (3, 4) located directly above the row transporter (9) suitable for leaving free the space located above said openings (7) for loading/unloading the semiconductor wafers,
- first means (13) of transferring the containers (1) from said temporary support means (12) to said storage means (10), and vice versa,
- second means (13) of transferring the containers (1) from said storage means (10) to said openings (7) for loading/unloading the semiconductor wafers, and vice versa,
- third means (13) of transferring the containers from said temporary support means (12) to said openings (7) for loading/unloading the semiconductor wafers, and vice versa.

2. System according to Claim 1, ***characterized in that*** said storage means (10) comprise a plurality of shelves (16) located in a volume entirely located above said semiconductor wafer processing tool or tools (3, 4) and behind said openings (7) for loading/unloading the wafers.

3. System according to Claim 2, **characterized in that** said storage shelves (16) extend over the length of said at least one row (2), and over several levels, one above the other.

4. System according to Claim 2 or 3, **characterized in that** said storage means (10) comprise a frame (18) comprising:
- a top part (22) to which is fixed the plurality of shelves (16) bearing overall on the frame (18),
- a floor (19) located above the semiconductor wafer processing tools (3, 4), said floor comprising a free area located along the shelves and the row, allowing an operator to move freely,
- pillars (20) supporting said floor, bearing on the ground.

5. System according to Claim 2 or 3, ***characterized in* that** said storage means (10) comprise a frame (18) comprising:
- a top part (22) to which is fixed the plurality of shelves (16) bearing overall on the frame (18),
- a floor (19) located above the semiconductor wafer processing tools (3, 4), said floor comprising a free area located along the shelves and the row, allowing an operator to move freely,
- means of suspending the floor and the top part as the ceiling in the row.

6. System according to Claim 4 or 5, ***characterized in* that** said floor (19) comprises means for allowing air to circulate vertically.

7. System according to any one of Claims 2 to 6, ***characterized* in that** said first, second and third means of transferring the containers are combined in a transfer mechanism (13) comprising means (14) of handling a container (1), means (15) of moving said handling means in the three directions in space, enabling said handling means to reach the openings (7) of the tool or tools (3, 4) for loading/unloading the wafers, the storage shelves (16) and the temporary support means (12).

8. System according to Claim 7, ***characterized in that*** said means (15) of moving the handling means (14) present at least three degrees of freedom in translation in three perpendicular directions X, Y, Z.

9. System according to Claim 8, **characterized in that** said transfer mechanism (13) comprises first guidance means (29) parallel to the row (2) enabling a degree of freedom in translation in the direction X to be obtained, second guidance means (30) enabling a degree of freedom in translation in the direction Z to be obtained, a carriage (31) carrying the handling means (14) and guided in translation on said first (29) or second (30) guidance means, the handling means being linked to said carriage by at least one link with a degree of freedom in translation in the direction Y.

10. System according to Claim 9, **characterized in that** said second guidance means (30) are free in translation on said first guidance means (29).

11. System according to Claim 9 or 10, **characterized in that** said first guidance means (29) have a length roughly equal to the length of the row (2) in that said second guidance means (30) have a height roughly equal to the height of the top part (22) of the frame (18).

12. System according to one of Claims 9 to 11, **characterized in that** said first (29) and second (30) guidance means are disposed set back towards the rear of the openings (7) of the tool or tools (3, 4) in a space located above the semiconductor wafer processing tool or tools, and in front of the storage shelves (16).

13. System according to Claim 12, ***characterized in* that** said handling means (14) are also linked to said carriage (31) via a vertical lifting system (36) enabling the handling means to access an area located below said carriage.

14. System according to any one of Claims 9 to 13,
**characterized in that** said link with a degree of freedom in translation in the direction Y between the handling means (14) and said carriage (31), is obtained by means of a device (37) enabling the handling means to move in the direction Y either side of the first (29) and second (30) guidance means.

15. System according to any one of Claims 1 to 14,
**characterized in that** it comprises means of moving said temporary support means (12) so as to enable a freedom of the space located above said openings (7) for loading/unloading the semiconductor wafers.

16. System according to Claim 15, ***characterized in* that** said means of moving said temporary support means (12) comprise a degree of freedom in translation along the Y axis, such that said temporary storage means can be moved along the Y axis between a first position, called "extracted position" projecting on the front panel and a second position, called "closed position" in which said support means (12) does not extend beyond the front panel (5, 6) of the processing tool or tools (3, 4).

## Patentansprüche

1. System für den Transport und die Lagerung von Halbleiterscheibenbehältern (1), das für die Verwendung in mindestens einem Feld (2) einer Halbleiterscheiben-Fabrik bestimmt ist, wobei dieses mindestens eine Feld mit einem oder mehreren Werkzeugen (3, 4) für die Bearbeitung der Halbleiterscheiben ausgestattet ist und diese Werkzeuge jeweils eine Vorderseite (5, 6) mit mindestens einer Öffnung (7) für die Eingabe/Entnahme der Halbleiterscheiben haben, welche einem Halbleiterscheibenbehälter (1) zugeordnet werden kann, wobei sämtliche Öffnungen für die Eingabe/Entnahme der Halbleiterscheiben des Bearbeitungswerkzeugs bzw. der Bearbeitungswerkzeuge ungefähr in einer vertikalen Ebene (8) angeordnet sind, und das besagte Feld von einem Feldförderer (9), der sich über dem bzw. den Bearbeitungswerkzeugen und parallel zu der vertikalen Ebenen befindet, mit Behältern versorgt wird,
***dadurch gekennzeichnet, dass*** das System folgende Teile beinhaltet:
- Mittel zur Lagerung (10) der Behälter in einem über dem Bearbeitungswerkzeug bzw. den Bearbeitungswerkzeugen für die Halbleiterscheiben befindlichen und im Verhältnis zu den Öffnungen für die Eingabe/Entnahme der Halbleiterscheiben nach hinten versetzten Bereich (11),
- Mittel zur vorübergehenden Ablage (12) mindestens eines Behälters, der dann an der Vorderseite (5, 6) des Bearbeitungswerkzeugs bzw. der Bearbeitungswerkzeuge (3, 4) vorsteht, wobei diese Mittel senkrecht zu dem Feldförderer (9) sind, so dass über den Öffnungen (7) für die Eingabe/Entnahme der Halbleiterscheiben noch Platz bleibt,
- erste Mittel für die Übergabe (13) der Behälter (1) von den Mitteln für die vorübergehende Ablage (12) an die Mittel für die Lagerung (10) und umgekehrt,
- zweite Mittel für die Übergabe (13) der Behälter (1) von den Mitteln für die Lagerung (10) an die Öffnungen (7) für die Eingabe/Entnahme der Halbleiterscheiben und umgekehrt,
- dritte Mittel für die Übergabe (13) der Behälter von den Mitteln für die vorübergehende Ablage (12) an die Öffnungen (7) für die Eingabe/Entnahme der Halbleiterscheiben und umgekehrt.

2. System nach Anspruch 1, ***dadurch gekennzeichnet, dass*** die Mittel für die Lagerung (10) mehrere, in einem Volumen angeordnete Regale (16) beinhalten, welches sich ganz über dem bzw. den Bearbeitungswerkzeugen (3, 4) für die Halbleiterscheiben und hinter den Öffnungen (7) für die Eingabe/Entnahme der Scheiben befindet.

3. System nach Anspruch 2, ***dadurch gekennzeichnet, dass*** die Lagerregale (16) auf der gesamten Länge des mindestens einen Feldes (2) und über mehrere übereinander angeordnete Etagen verlaufen.

4. System nach Anspruch 2 oder 3, ***dadurch gekennzeichnet, dass*** die Mittel zur Lagerung (10) aus einem Gestell (18) bestehen, das Folgendes beinhaltet:
- einen oberen Teil (22), an dem die Regale (16) befestigt sind, die alle auf dem Gestell (18) aufliegen,
- eine Bodenplatte (19), die sich über den Bearbeitungswerkzeugen (3, 4) für die Halbleiterscheiben befindet und über die ganze Länge der Regale und des Feldes Spielraum für eine Bedienkraft lässt,
- auf dem Boden aufstehende Träger (20) für die Bodenplatte.

5. System nach Anspruch 2 oder 3, ***dadurch gekennzeichnet, dass*** die Mittel für die Lagerung (10) aus einem Gestell (18) bestehen, das:
- einen oberen Teil (22) hat, an dem die Regale (16) befestigt sind, die alle auf dem Gestell aufliegen,
- eine Bodenplatte (19) hat, die sich über den Bearbeitungswerkzeugen (3, 4) für die Halbleiterscheiben befindet und über die ganze Länge der Regale und des Feldes Spielraum für eine Bedienkraft lässt,
- Mittel zur Aufhängung der Bodenplatte und des oberen Teils an der Decke in dem Feld hat.

6. System nach Anspruch 4 oder 5, ***dadurch gekennzeichnet, dass*** die Bodenplatte (19) mit Mitteln für die vertikale Luftzirkulation versehen ist.

7. System nach einem der Ansprüche 2 bis 6, ***dadurch gekennzeichnet, dass*** die ersten, zweiten und dritten Mittel zur Übergabe der Behälter in einem Übergabemechanismus (13) vereint sind, der mit Mitteln zur Aufnahme (14) eines Behälters (1) und zum räumlichen Verfahren (15) der Aufnahmemittel in drei Richtungen versehen ist, so dass die Übergabemittel die Öffnungen (7) des Werkzeugs bzw. der Werkzeuge für die Eingabe/Entnahme der Scheiben, die Lagerregale (16) und die Mittel für die vorübergehende Ablage (12) erreichen können.

8. System nach Anspruch 7, ***dadurch gekennzeichnet, dass*** die Mittel zum Verfahren (15) der Aufnahmemittel (14) mindestens drei Freiheitsgrade für die Parallelverschiebung in drei senkrechte Richtungen X, Y und Z besitzen.

9. System nach Anspruch 8, ***dadurch gekennzeichnet, dass*** der Übergabemechanismus (13) erste, parallel zum Feld (2) verlaufende Mittel (29) zur Führung beinhaltet, um einen Freiheitsgrad für die Parallelverschiebung in X-Richtung herzustellen, ferner zweite Mittel (30) zur Führung, um einen Freiheitsgrad für die Parallelverschiebung in Z-Richtung herzustellen, einen Schlitten (31) mit den Aufnahmemitteln (14), der in Parallelverschiebung an den ersten (29) oder zweiten (30) Mitteln zur Führung verfahren wird, wobei die Aufnahmemittel über mindestens eine Verbindung mit einem Freiheitsgrad für die Parallelverschiebung in Y-Richtung mit dem Schlitten verbunden ist.

10. System nach Anspruch 9, ***dadurch gekennzeichnet, dass*** sich die zweiten Mittel (30) zur Führung an den ersten Mitteln (29) zur Führung frei parallel verschieben lassen.

11. System nach Anspruch 9 oder 10, ***dadurch gekennzeichnet, dass*** die ersten Mittel zur Führung (29) insofern ungefähr die gleiche Länge haben wie das Feld (2), als die zweiten Mittel (30) zur Führung ungefähr die gleiche Höhe haben wie der obere Teil (22) des Gestells (18).

12. System nach einem der Ansprüche 9 bis 11, ***dadurch gekennzeichnet, dass*** die ersten (29) und zweiten (30) Mittel zur Führung im Verhältnis zu den Öffnungen (7) des Werkzeugs bzw. der Werkzeuge (3, 4) in einem Raum über dem Werkzeug bzw. den Werkzeugen für die Bearbeitung der Halbleiterscheiben nach hinten versetzt und vor den Lagerregalen (16) angeordnet sind.

13. System nach Anspruch 12, ***dadurch gekennzeichnet, dass*** die Aufnahmemittel (14) außerdem über ein vertikales Hubsystem (36) mit dem Schlitten (31) verbunden sind, das den Aufnahmemitteln den Zugang zu einem unter dem Schlitten befindlichen Bereich ermöglicht.

14. System nach einem der Ansprüche 9 bis 13, ***dadurch gekennzeichnet, dass*** die Verbindung mit einem Freiheitsgrad für die Parallelverschiebung in Y-Richtung zwischen den Aufnahmemitteln (14) und dem Schlitten (31) mit Hilfe einer Vorrichtung hergestellt wird, durch die die Aufnahmemittel auf beiden Seiten der ersten (29) und zweiten (30) Mittel zur Führung in Y-Richtung verfahren werden können.

15. System nach einem der Ansprüche 1 bis 14, ***dadurch gekennzeichnet, dass*** es Mittel zum Verfahren der Mittel für die vorübergehende Ablage (12) beinhaltet, so dass über den n Öffnungen (7) für die Eingabe/Entnahme der Halbleiterscheiben Platz bleibt.

16. System nach Anspruch 15, ***dadurch gekennzeichnet, dass*** die Mittel zum Verfahren der Mittel für die vorübergehende Ablage (12) einen Freiheitsgrad für die Parallelverschiebung entlang der Y-Achse besitzen, so dass die Mittel für die vorübergehende Lagerung zwischen einer ersten, aus der Vorderseite vorstehenden, so genannten "eingezogenen Position" und einer zweiten, so genannten "geschlossenen Position" entlang der Y-Achse verfahren werden können, in der das Mittel zur Ablage (12) nicht aus der Vorderseite (5, 6) des bzw. der Bearbeitungswerkzeuge (3, 4) hervorragt.
